Europäisches Patentamt

European Patent Office

Office européen des brevets

(19)

(11) **EP 0 516 516 B1**

(12) **FASCICULE DE BREVET EUROPEEN**

(45) Date de publication et mention
de la délivrance du brevet:
**11.11.1998 Bulletin 1998/46**

(51) Int Cl.⁶: **H01L 29/94**, H01L 27/10,
G11C 16/02

(21) Numéro de dépôt: **92401408.7**

(22) Date de dépôt: **22.05.1992**

(54) **Mémoire avec cellule mémoire EEPROM à effet capacitif et procédé de lecture d'une telle cellule mémoire**

Speicher mit kapazitiver EEPROM-Speicherzelle und Verfahren zum Lesen dieser Speicherzelle

Memory with capacitive EEPROM cell and process for reading such a memory cell

(84) Etats contractants désignés:
**DE ES GB IT NL**

(30) Priorité: **29.05.1991 FR 9106466**

(43) Date de publication de la demande:
**02.12.1992 Bulletin 1992/49**

(73) Titulaire: **GEMPLUS**
**13420 Gemenos (FR)**

(72) Inventeur: **Kowalski, Jacek**
**F-75116 Paris (FR)**

(56) Documents cités:
**US-A- 4 037 243      US-A- 4 242 736**
**US-A- 4 663 645**

## Description

La présente invention a pour objet une mémoire EEPROM (Electrically Erasable and Programmable Read Only Memory) munie d'une cellule mémoire à mémorisation capacitive. Elle concerne aussi le procédé de lecture d'une telle cellule mémoire. Elle trouve son application dans le domaine des mémoires non volatiles. Celui-ci correspond aux cellules mémoires munies chacune d'un transistor à grille flottante comme organe de mémorisation. Le but de l'invention est d'augmenter la densité d'intégration de ces cellules sur un même substrat semiconducteur. Les cellules de l'invention permettent de stocker d'une façon durable un état logique binaire (1 ou 0), ou autre, même si on coupe l'alimentation du circuit électronique auquel elles sont connectées. Les avantages des cellules de l'invention sont les suivants:

- très faible taille géométrique de la cellule, d'où possibilité des réaliser des mémoires très denses;
- consommation de courant nulle en lecture et en programmation, ce qui est très intéressant pour des cartes à puces sans contact ou dans le domaine spatial;
- utilisation de technologies de fabrication standard existantes, celles des cellules dites EEPROM ou des cellules dites FLASH-EEPROM;
- possibilité d'écrire un 0 ou un 1 dans une seule cellule à la fois au lieu de devoir traiter tout un bloc;
- plus grande rapidité de lecture grâce à une lecture à courant nul.

On connaît les cellules mémoires non volatiles comportant un transistor à grille flottante. On stocke des charges électriques sur cette grille flottante. Le transistor conduit ou se bloque suivant l'état mémorisé, suivant le type ou le nombre des charges stockées. Ces cellules sont de trois types. On distingue les cellules EPROM, les cellules EEPROM et les cellules FLASH-EEPROM. Avec une cellule EPROM, la grille flottante peut être chargée d'électrons ou déchargée. Le transistor à grille flottante conduit quand la grille flottante est déchargée. La densité d'intégration de ces cellules est bonne mais le courant de programmation (pour injecter les électrons dans la grille flottante) est important. La tension de programmation doit donc être fournie depuis l'extérieur du circuit intégré qui comporte la mémoire. Ces cellules ne sont pas effaçable électriquement: elles doivent être effacées par un rayonnement ultraviolet, ce qui provoque en outre l'effacement de toute la mémoire et non pas d'une seule cellule à la fois. Pour la lecture d'une telle cellule, comme pour la lecture des cellules des deux autres types, on mesure l'intensité d'un courant dit de lecture passant au travers de ce transistor.

Avec une mémoire EEPROM, l'accès à une cellule doit être établi au travers d'un transistor d'accès: la densité d'intégration en est réduite par quatre. L'oxyde de grille interposé entre la grille flottante et le canal de conduction du transistor est bien plus faible que pour une cellule EPROM, il est de l'ordre de 7nm. Le transistor à grille flottante conduit lorsque la grille flottante est chargée de trous, il se bloque lorsqu'elle est chargée d'électrons. Les cellules sont programmables et effaçables par bloc.

Les cellules FLASH-EEPROM ont une allure technologique du même type que les EEPROM, mais sans transistor d'accès. Leur densité d'intégration est plus grande. Cependant, le procédé de fabrication est difficile à mettre au point, au moment de la programmation le temps de programmation est très long (quelques secondes), et les tensions de seuil de programmation doivent être très précisément contrôlées. La cellule consomme du courant en effacement et en lecture.

Les grilles de toutes ces cellules sont de préférence l'une au dessus de l'autre, mais il est tout à fait envisageable de réaliser une grille de commande enterrée, surmontée de la grille flottante. Cette dernière vient ensuite surplomber le bord d'une région de drain d'un transistor, ou tout simplement une région dopée. Il en sera de même pour les cellules de l'invention bien que, pour simplifier, la présente description concerne plus précisément les structures à empilage.

Une cellule, dans l'état de la technique ou dans l'invention, est dite programmée si elle a reçue des trous sur sa grille flottante. Elle est dite effacée si elle a reçu des électrons. Quand elle est programmée son seuil de conduction est négatif: par exemple la valeur de ce seuil est - 2 V. Ainsi cette cellule se mettrait à conduire si la tension appliquée sur sa grille de commande de son transistor était supérieure à - 2 V, alors qu'elle est polarisée par 5 V sur son drain et 0 V sur sa source. Quand elle est effacée son seuil de conduction est positif: par exemple 4 V, dans les mêmes conditions que ci-dessus. Le seuil de conduction est donc plus grand dans l'état effacé que dans l'état programmé.

L'invention a pour objet de remédier aux inconvénients cités en mettant en oeuvre un principe physique différent de celui de la conduction des transistors à grille flottante. Dans l'invention on surveille la variation de la capacité d'un transistor ou plutôt d'un dispositif de type MOS à grille flottante en fonction de la tension appliquée sur sa grille de commande. On constate en effet qu'il existe une capacité entre la grille flottante et le drain du transistor, de même qu'il existe une capacité entre cette grille flottante et le substrat semiconducteur, à l'endroit du canal de conduction. Cette dernière capacité varie d'une part fortement selon que le transistor est passant ou non. Soit cette capacité existe entre la grille flottante et le substrat si la tension de la grille de commande est inférieure au seuil de conduction du transistor (et alors elle est faible); soit elle existe entre la grille flottante et le canal de conduction créé par le transistor si la tension de la grille flottante dépasse la tension de seuil de conduction du transistor (et alors elle est forte). D'autre part, quand le transistor conduit cette capacité grille flottante-canal de conduction s'additionne à la capacité grille flottante-drain puisqu'elle lui est connectée en parallèle par le canal de conduction.

Dans l'invention, la cellule proposée a son drain et sa source court-circuités, ou bien même l'un d'entre eux n'existe même pas. Il n'y a donc plus a proprement parlé de transistor. L'existence ou non d'un canal de conduction s'explique cependant de la manière suivante. Il existe quand la tension sur la grille de commande est supérieure à la tension de seuil. Quand ce canal existe la capacité grille flottante-canal existe. Par contre entre les grilles flottantes (en polysilicium de premier niveau) et les grilles de commande (en polysilicium de deuxième niveau dans les structures à empilage) ou entre elles et la zone de conduction du transistor, ou le substrat semiconducteur, il n'y a aucun courant.

Si le canal n'existe pas, la capacité entre la grille flottante et le substrat subsiste. Celle-ci est cependant faible pour une tension de la grille de commande avoisinante ou inférieure à la tension de seuil. La capacité qui est utilisée dans le dispositif de l'invention est la capacité entre la grille flottante et une ligne de bit constituée schématiquement par un drain. Quand la tension de la grille de commande dépasse la tension du seuil, le canal est créé. Il existe alors une connexion électrique entre le canal et une diffusion de drain, ou de source, servant de ligne de bit. Si cette tension est inférieure à cette valeur, même si le canal existe, il n'y a en fait pas de connexion électrique entre le canal et la diffusion drain ou source. Ceci est dû à la présence de la zone désertée créée autour de la diffusion ($n^+$) de ce drain ou de cette source. Ce comportement est utilisé pendant la lecture.

L'invention a donc pour objet une cellule mémoire d'un circuit intégré dans un substrat semiconducteur, comportant une grille de commande commandant et étant isolée d'une grille flottante, cette grille flottante étant isolée du substrat semiconducteur, cet isolement comportant au moins une fenêtre en un oxyde tunnel, caractérisée en ce que cette grille surmonte en partie à l'endroit de cette fenêtre en oxyde tunnel une région unique de ce substrat dopée avec des impuretés d'un type opposé aux impuretés qui dope le substrat alentour de cette région unique. La fenêtre tunnel peut par ailleurs occuper toute la surface de l'isolement entre la grille flottante et le substrat. Dans la cellule de l'invention il n'y a que deux accès : un sur la grille de commande et un sur la région. Il n'y a pas alors de région pouvant constituer une source, et qui serait reliée par ailleurs à la masse ou à un autre potentiel.

Elle a également pour objet une cellule mémoire d'un circuit intégré dans un substrat semiconducteur, comportant une grille de commande commandant et étant isolée d'une grille flottante, cette grille flottante étant isolée du substrat semiconducteur, cet isolement comportant au moins une fenêtre en un oxyde tunnel au dessus d'un canal de conduction d'un transistor réalisé dans le substrat semiconducteur, caractérisée en ce que les régions drain et source de ce transistor sont reliées électriquement. Dans ce sens on comprendra comme formant un transistor au sens de l'invention tout couple de régions diffusées dans le substrat, court-circuitées ensemble, et surmonté d'une grille flottante.

Elle a enfin pour objet un procédé de lecture d'une cellule mémoire dans une mémoire munie de cellules avec dispositif à grille flottante, ce dispositif comportant une grille de commande reliée à une ligne de mot et une région source, ou une région drain, reliée à une ligne de bit, cette cellule étant dans un état programmée ou effacée, le seuil de conduction d'un canal de conduction du dispositif à grille flottante étant plus faible dans l'état programmé que dans l'état effacé, caractérisé en ce que

- on précharge les lignes de bit à une tension dont la valeur est au moins égale à la valeur absolue du seuil de conduction de la cellule pour un état programmé pour minimiser les capacités des lignes de bit,
- on sélectionne la ligne de bit et la ligne de mot concernées par la cellule à lire, et
- on compare à une tension de référence la tension restant sur la ligne de bit sélectionnée et on en déduit l'état lu.

L'invention sera mieux comprise à la lecture de la description qui suit et à l'examen des figures qui l'accompagnent. Celles-ci ne sont données qu'à titre indicatif et nullement limitatif d l'invention. Les figures montrent:

- figures 1a à 1c: une représentation schématique de l'architecture des capacités dans un transistor ou plus généralement dans un dispositif à grille flottante;
- figures 2a et 2b: des diagrammes montrant l'évolution de la capacité grille flottante-drain du dispositif à grille flottante, en fonction de la tension appliquée sur la grille de commande, dans le cas d'une cellule effacée ou programmée respectivement;
- figure 3: une mémoire selon l'invention et les particularités de son système de lecture;
- figures 4a à 4g: des diagrammes temporels montrant pour trois utilisations de la mémoire les tension appliquées dans son circuit de commande;
- figures 5a et 5b: une représentation simplifiée des tensions applicables sur des lignes de bit et ligne de mot de la mémoire pour programmer ou effacer respectivement une cellule mémoire ;
- figure 6 : un schéma d'implantation de cellules mémoires de la mémoire dans un substrat semiconducteur.

Les figures 1a à 1c montrent des cellules selon l'invention de divers types : respectivement théorique, dérivée d'une cellule EEPROM, ou dérivée d'une cellule FLASH-EEPROM. Sur ces figures un substrat semiconducteur T contient une cellule selon l'invention. Celle-ci est munie d'une grille de commande GC, réalisée en une couche de polysilicium de deuxième niveau. La grille GC est séparée par une couche d'oxyde d'une grille flottante GF, réalisée en une couche de polysilicium de premier niveau. La grille GF est séparée du substrat T, au moins en un endroit, par une couche d'oxyde tunnel OT de faible épaisseur. Dans le cas de la cellule dérivée d'une cellule EEPROM, sous l'oxyde OT on trouve dans le substrat une implantation tunnel IT favorisant l'injection des charges électroniques dans la grille GF. Dans le cas de la cellule dérivée de la cellule FLASH-EEPROM, tout l'oxyde sous la grille GF est un oxyde tunnel de faible épaisseur e.

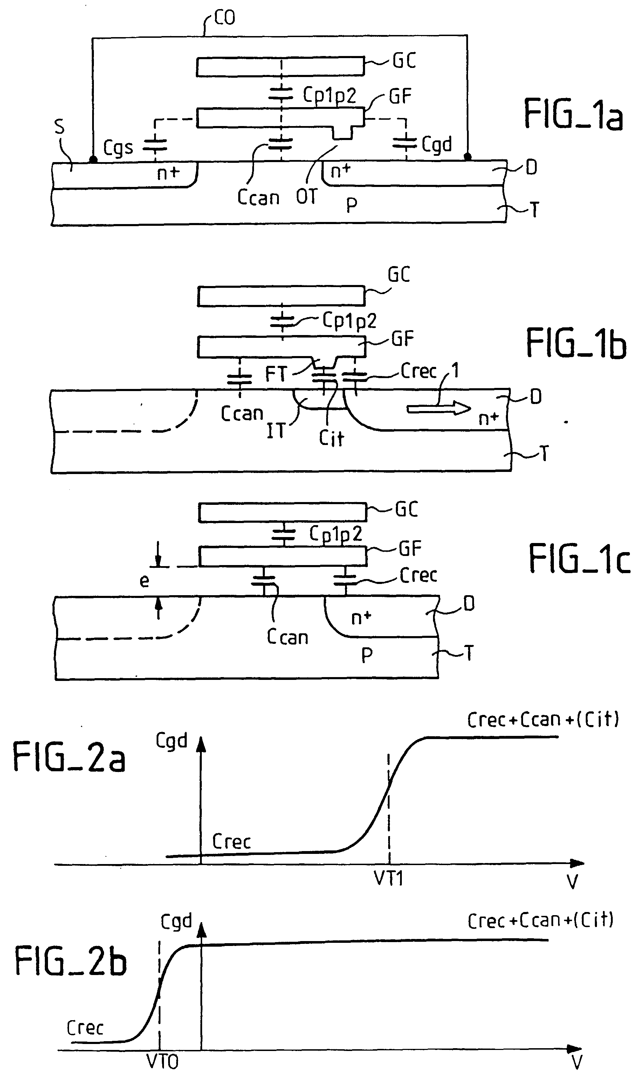

Dans le cas de la figure la, la grille GF est superposée sur le canal de conduction d'un transistor comportant une source S et un drain D reliés entre eux par une connexion CO. Dans le cas des figures 1b et 1c les sources ne sont pas réalisées. Si elles le sont elles sont également connectées aux drains D. Les drains ou sources sont réalisés sous forme de diffusion $n^+$ dans le substrat T de type p. En pratique la meilleure cellule, celle qui prend le moins de place est celle dans laquelle les régions sources ne sont pas réalisées parce qu'en fait elles sont inutiles.

Les capacités existant entre ces différents éléments du dispositif à grille flottante sont les suivantes:

- Cp1p2 capacité entre la grille GC et la grille GF.
- Cgd capacité entre la grille GF et le drain D (ou plutôt la diffusion assimilée à ce drain).
- Cgs capacité entre la grille GF et la source S du transistor. Dans la mesure où S est reliée à D par une connexion CO, ou dans la mesure où S n'existe même pas, on assimilera Cgs à Cgd.
- Ccan capacité existant entre la grille GF et le substrat T quand la tension sur la grille GC est supérieure à la tension de seuil de conduction du transistor.
- Cgt capacité entre grille GF et substrat T quand le transistor ne conduit pas. Elle est négligeable.

La capacité Cgd elle-même se décompose en capacité de recouvrement Crec entre la partie du drain qui va sous la grille GF et la grille GF elle-même, et en capacité d'implantation tunnel Cit. Cette dernière n'est ici visible que dans la variante dérivée de la technologie EEPROM où une implantation tunnel est effectuée sous la partie d'oxyde tunnel.

Ces capacités sont mises en circuit de la manière suivante. La capacité Cp1p2 est en série avec les capacités Cgd et Ccan. Lorsque le canal est connecté ces deux dernières capacités s'additionnent et jouent ensemble le rôle de la capacité Cgd. Quand il nest pas connecté, seule la capacité intrinsèque Cgd intervient dans le schéma équivalent de connexion. Cette dernière, quand elle intervient seule, est équivalente à Crec. L'évolution de la capacité grille flottante-drain en fonction de la tension appliquée sur la grille de commande GC est représentée sur les figures 2a et 2b. Respectivement, dans l'état effacé (un 1 est écrit dans la cellule) la tension de seuil de création de la connexion du canal est VT1. Dans un exemple VT1 vaut 4 Volts. Dans l'état programmé (un 0 est écrit dans la cellule) le seuil de création de la connexion du canal est VT0. Dans un exemple VT0 vaut - 2 Volts. Dès que la tension sur la grille GC devient supérieure à la tension de seuil la capacité Cgd passe de la valeur Crec à la valeur Crec + Ccan + Cit (éventuellement pour cette dernière).

Le fonctionnement de la cellule est le suivant. Grâce à l'existence d'une fenêtre tunnel (de 10nm environ d'épaisseur) des charges peuvent être conduites sur la grille GF si on applique un champ électrique suffisamment grand (de l'ordre de 10 Mv/cm) à travers l'oxyde tunnel. Ce champ est obtenu en portant la grille GC à environ 20 V quand le drain est à 0 V, ou vice versa. Suivant la direction du champ appliqué, on stocke soit des électrons soit des trous. L'apport de ces charges sur la grille flottante permet de modifier la tension de seuil du transistor MOS, vue de la grille GC. Cette programmation est similaire dans son principe à celle des cellules EEPROM ou FLASH-EEPROM de l'état de la technique.

Pour une cellule effacée la capacité de la cellule vue de la grille GC est :

$$Ca0 = Cp1p2 . Crec / (Cp1p2 + Crec)$$

Pour une cellule programmée la capacité de la cellule vue de la grille GC est :

$$Ca1 = Cp1p2 . (Ccan + Crec) / (Cp1p2 + Ccan + Crec)$$

L'inconvénient d'une cellule capacitive dérivée d'une cellule EEPROM vient de ce que la capacité Crec est relativement grande (il y a alors moins de différence entre Ca0 et Ca1), ce qui détériore la sensibilité en lecture. Pour diminuer cette capacité Crec, la fenêtre tunnel FT est repoussée vers le bord de la grille GF, dans le sens de la flèche 1 par exemple.

Dans la technologie dérivée de la technologie FLASH-EEPROM, où tout l'oxyde de grille GF est un oxyde tunnel, on peut pour améliorer la programmation ou l'effacement ajouter une implantation de type LDD sur le drain pour l'étendre légèrement sous la grille GF. Ceci comporte l'avantage de minimiser la capacité Crec et ainsi d'avoir une cellule la plus petite possible.

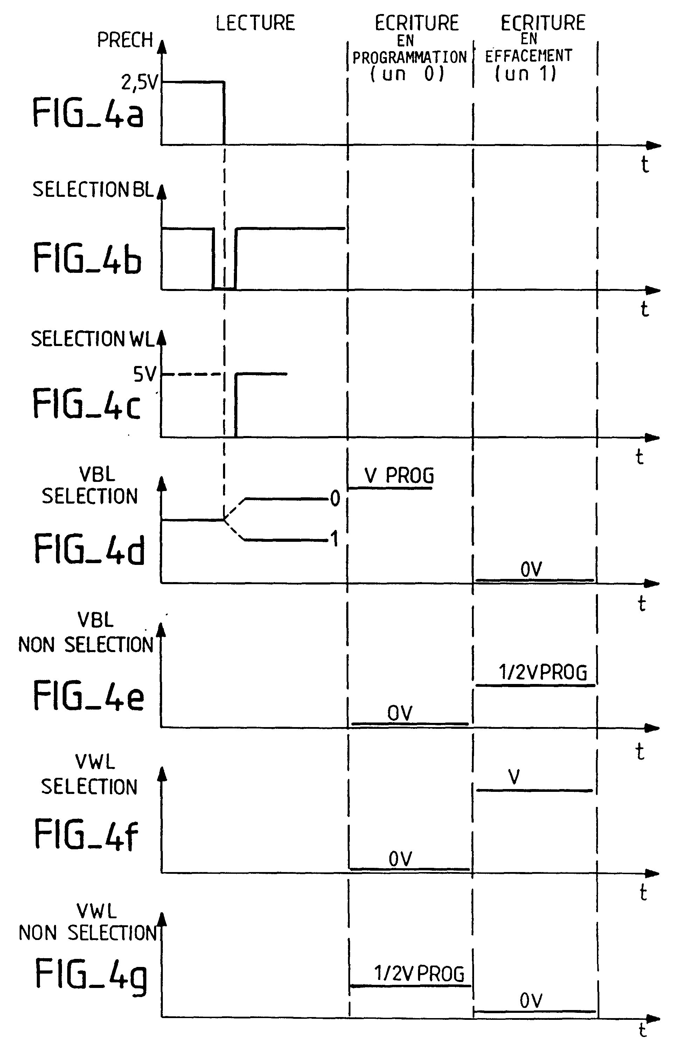

la figure 3 montre une mémoire selon l'invention avec une cellule mémoire C1 comportant un transistor à grille flottante 1. La grille flottante 2 de ce transistor est interposée entre une grille de commande 3 et un drain 4 et une source 5 reliés entre eux. La grille 3 est reliée à une ligne de mot WL0, et les drain 4 et source 5 sont reliés ensemble à une ligne de bit BL0. Les autres cellules C2 à Cn et Cm sont représentées schématiquement par leur capacité équivalente Ca connectée entre une des lignes de bit BL0 à BLm et une des lignes de mot WL0 à Wln. La cellule C3 adopte un symbolisme montrant clairement qu'il n'y a qu'une diffusion utile dans le dispositif de l'invention. Les lignes de bit et de mot sont arrangées matriciellement. Elles sont également en relation avec des décodeurs respectivement 6 et 7 de décodage de ligne de bit et de décodage de ligne de mot. Ces décodeur reçoivent des signaux d'adresse permettant de sélectionner chaque cellule à son tour, ou éventuellement plusieurs en même temps. Cette solution est symbolisée ici par la commande de transistors, montés en série avec les lignes de bit et devenant passant quand il reçoivent un signal décodé par le décodeur. La ligne de bit sélectionnée est alors mise en circuit avec le système de lecture. La mémoire comporte aussi un circuit de précharge alimenté par une tension de précharge supérieure à IVT0I et commandé par un signal de précharge PRECH. Le signal PRECH est appliqué sur la grille de commande d'un transistor 8 interposé entre une connexion Vbl reliée à une entrée ligne de bit du décodeur et à l'alimentation de précharge. La tension doit être supérieure à IVT0I parce que, d'une cellule à l'autre, la tension de seuil peut varier et qu'il vaut mieux prendre des précautions.

La mémoire comporte encore, dans un exemple, deux lignes de bits supplémentaires BLT0 et BLT1. Ces deux lignes de bits sont reliées entre elles et à une connexion Vdum. Une des lignes de bit, BLT0 ne dessert que des cellules programmées, l'autre BLT1 que des cellules effacées.

Un circuit 9 de lecture comporte un amplificateur différentiel recevant les signaux dispensé sur les connexions Vbl et Vdum. Cet amplificateur différentiel de type connu comporte deux branches 10 et 11 entre l'alimentation générale Vcc du circuit et la masse électrique. Chaque branche comporte un transistor de type P, respectivement 12 et 13, en série avec un transistor de type N, respectivement de 14 et 15. Les grilles de commande des transistors 12 et 13 sont reliées entre elles et entre le transistor 12 et le transistor 14. Le transistor 14 a sa grille de commande reliée à la connexion Vbl. Le transistor 15 a sa grille de commande reliée à la connexion Vdum. La sortie 5 de lecture de la mémoire est le point milieu entre les transistors 13 et 15. Les deux branches 10 et 11 sont reliées ensemble à la masse par un transistor de liaison établissant cet liaison aux moments opportuns pour éviter de faire débiter le circuit 9 de lecture inutilement en dehors de ces moments.

Les figures 4a à 4g montrent des diagrammes temporels respectivement des signaux de précharge, de sélection ou d'adressage de ligne de bit, de sélection ou d'adressage de ligne de mot, et de de signaux disponibles sur la ligne de bit de la cellule sélectionnée, sur les lignes de bit des cellules non sélectionnées, sur la ligne de mot de la cellule sélectionnée, et sur celles des cellules non sélectionnées.

Pour la lecture, pendant la durée d'un ordre de précharge, par exemple toutes les lignes de bit sont préchargées. Elles sont préchargées au minimum à IVT0I qui représente la tension de seuil d'une cellule programmée. Dans l'exemple où VT0 vaut - 2 Volts, on précharge donc les lignes de bit à plus que 2 Volts, par exemple à 2,5 Volts. Ceci permet de minimiser la capacité de chaque ligne de bit. En effet, la capacité Ccan d'une cellule programmée ne s'ajoute plus à la capacité Crec de cette cellule si la tension de drain de cette cellule est supérieure à IVT0I. Avec cette condition la capacité en précharge d'une ligne de bit est égale à Cbl (capacité parasite de la connexion de ligne de bit elle-même) plus n fois Crec s'il y a n cellules sur la même ligne de bit.

Pendant la lecture, après la précharge, seule la ligne de bit reliée à la cellule à sélectionner est reliée à l'amplificateur 9. De même pendant la lecture seule la ligne de mot correspondant à la cellule à sélectionner est portée à V Volts, par exemple 5 Volts, ou même plus si on utilise une technique de multiplication de tension. Les autres lignes de mot restent à 0 Volts. Par exemple WL0 est portée à 5 Volts. La sélection de la ligne de mot est ultérieure à la fin de la précharge.

Considérons que la cellule C1 est dans un état programmé et qu'elle est lue. Au moment de la lecture elle fait passer sur la ligne de bit BL1 une variation de tension égale à

$$\delta V = V \cdot Ca / (Ca + Cbltot)$$

où V vaut dans l'exemple 5 Volts, où Ca est la capacité équivalente de la cellule et Cbltot la capacité de la totalité de la ligne de bit. On peut écrire encore que

$$\delta V = (Vbl - IVT0I) \cdot Cgd / (Cgd + Cbltot) +$$

$$(V-Vbl+IVT0I) \cdot (Cgd+Ccan)/(Cgd+Ccan+Cbltot)$$

Le premier terme est dû à la capacité Cgd avant que la ligne de mot ne dépasse la tension de création du canal. Le deuxième terme représente la tension passée sur la ligne de bit après que la connexion de canal soit créée.

Si la cellule C1 est dans un état effacé au moment de la lecture, la tension qui passe sur la ligne de bit est seulement

$$\delta V = V \ . \ Cgd / (Cgd + Cbltot)$$

puisque comme V (égal à 5 Volts) est inférieur à IVT1I + Vbl (égal à 4 Volts + 2,5 Volts) la capacité Ccan n'est pas utilisée dans le couplage : il n'y a pas de canal connecté à la diffusion n$^+$.

Pour effectuer la détection de l'état de la cellule lue on compare la tension finale sur la ligne de bit avec une tension de référence. La tension de référence est une tension moyenne, délivrée par les lignes de bit BLT0 et BLT1 reliées entre elles, entre la tension délivrée par une cellule effacée et une cellule programmée lues ensemble.

Pour la détection d'un état programmé (un 0), on obtient, dans le cas idéal où Crec est très inférieur à Ccan et où Ccan est de l'ordre du vingtième de Cbltot:

$$\delta V0 = 0,023 \ ( \ V - Vbl + IVT0I \ )$$

Pour la détection d'un état effacé (un 1), on obtient, dans le cas idéal où Crec est très inférieur à Ccan et où Ccan est de l'ordre du vingtième de Cbltot:

$$\delta V1 = - \ 0,024 \ ( \ V - Vbl + IVT0I \ )$$

On s'aperçoit que les valeurs de $\delta V$ sont environ symétriques par rapport à la tension moyenne de comparaison. Par exemple avec les valeurs données jusqu'ici elles valent $\delta V0 = 104 \, mV$ et $\delta V1 = - 109 \, mV$. L'amplificateur différentiel 9 est capable de détecter ces différences.

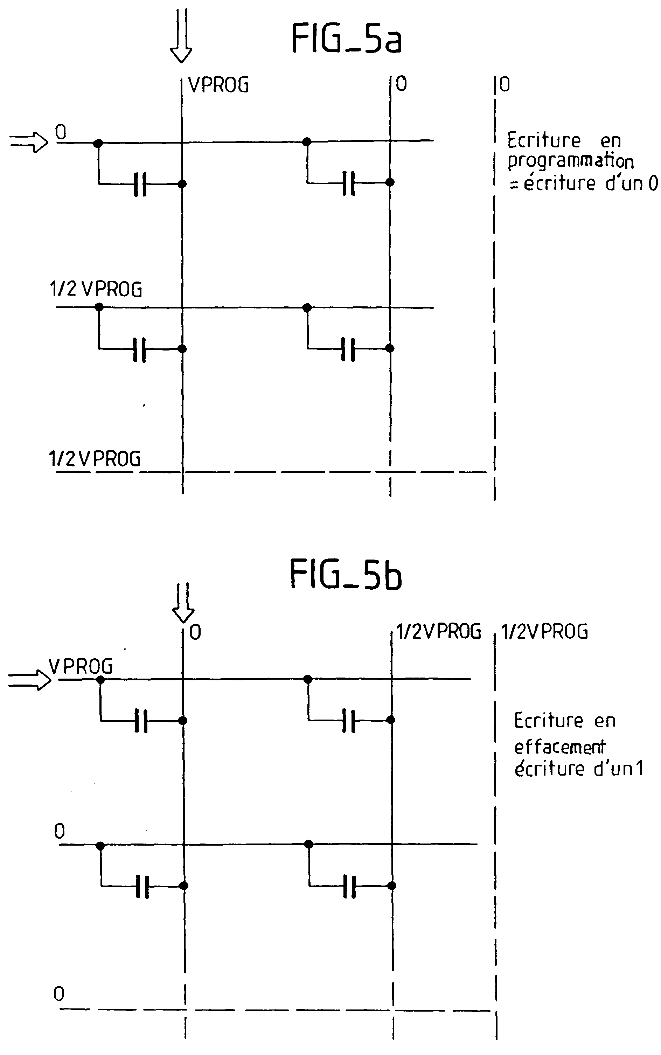

Les figures 5a et 5b montrent les tensions à appliquer sur les lignes de bit et de mot concourant à une cellule sélectionnée à programmer ou à effacer (pointées par des flèches), ainsi que celles qu'il faut appliquer pendant ces ces opérations sur les autres lignes concourant aux cellules non sélectionnées. Pendant la programmation, on applique la tension de programmation VPROG par la ligne de bit sur le drain, et 0 Volts par la ligne de mot sur la grille de la cellule sélectionnée. Pour ne pas affecter l'état des autres cellules, on applique la moitié de la tension de programmation sur toutes les lignes de mot non sélectionnées et 0 Volts sur les lignes de bits où la cellule ne doit pas changer d'état. Pour l'effacement on inverse le sens du champ électrique. Pour cela on applique VPROG sur la grille par l'intermédiaire de la ligne de mot, et 0 Volts sur le drain par l'intermédiaire de la ligne de bit de la cellule sélectionnée. Pour ne pas affecter le contenu des autres cellules, on porte les lignes de bit dont les cellules ne doivent pas changer d'état à 1/2 VPROG et toutes les autres lignes de mots à 0 Volts.

Un grand avantage de cette structure est qu'on puisse effacer ou programmer une seule cellule à la fois. Mais on peut aussi programmer ou effacer des lignes entières. Par exemple pour effacer toutes les cellules d'une ligne on la porte à VPROG en maintenant toutes les lignes de bit à 0. Pour les lignes ou colonnes non sélectionnées la tension 1/2 VPROG est utilisée. Elle permet d'avoir sur les cellules non sélectionnées un champ électrique deux fois moins fort, insuffisant pour déclencher un effet tunnel nécessaire à la programmation ou l'effacement.

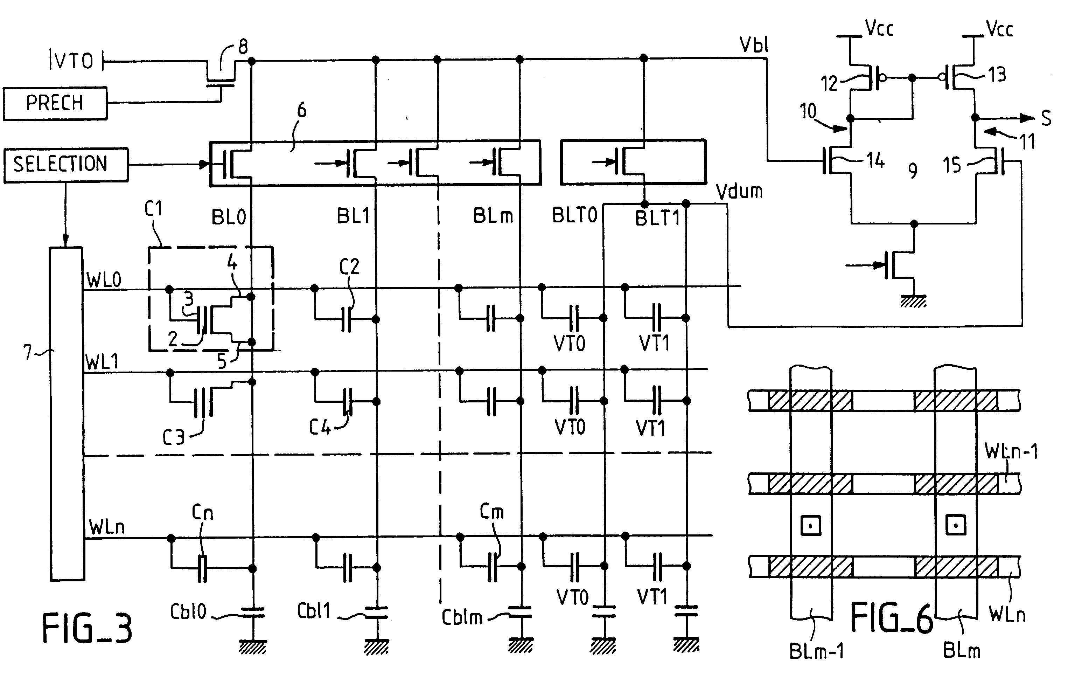

La figure 6 montre les lignes de mot WLn, WLn-1 réalisées sous forme de bande de polysilicium de deuxième niveau et susceptible de jouer en elles même le rôle de grille de commande lorsqu'elles sont placées au-dessus (avec un isolement) de plaques gravées, marquées avec des hachures, réalisées en polysilicium de premier niveau et jouant le rôle de grilles flottantes. Entre la ligne WLn et la ligne WLn-1, on a diffusé dans le substrat une région de "drain", parallèlement à ces lignes de mot, et légèrement en dessous dans le cas où il y a recouvrement. Entre ces deux lignes de mots, au droit de l'alignement des plaques on réalise des connexions électriques entre ses diffusions de drain et les lignes de bit métallisées BLm, BLm-1 surmontant les lignes de mot et étant perpendiculaires à ces dernières. Les diffusions de drain et les connexions avec les lignes de bit peuvent prendre place entre chaque ligne de mot, cellule C1, ou une fois sur deux, cellule C3.

## Revendications

1. Cellule mémoire d'une mémoire en circuit intégré réalisé dans un substrat semiconducteur, comportant une grille de commande commandant et étant isolée d'une grille flottante, cette grille flottante étant isolée du substrat semiconducteur, cet isolement comportant au moins une fenêtre en un oxyde à effet tunnel, caractérisée en ce que cette cellule ne comporte qu'une région diffusée unique dans le substrat, cette grille surmontant en partie, à l'endroit de cette fenêtre en oxyde à effet tunnel, cette région unique de ce substrat, cette région unique étant dopée avec des impuretés d'un type opposé aux impuretés qui dope le substrat alentour de cette région unique.

2. Cellule mémoire d'une mémoire en circuit intégré réalisée dans un substrat semiconducteur, comportant une grille de commande commandant et étant isolée d'une grille flottante, cette grille flottante étant isolée du substrat semiconducteur, cet isolement comportant une fenêtre en un oxyde à effet tunnel au dessus d'un canal de conduction d'un transistor réalisé dans le substrat semiconducteur, caractérisée en ce que les régions drain et source de ce transistor sont reliées électriquement.

3. Cellule mémoire d'une mémoire en circuit intégré réalisée dans un substrat semiconducteur, comportant une grille de commande commandant et étant isolée d'une grille flottante, cette grille flottante étant isolée du substrat semiconducteur par un oxyde à effet tunnel, caractérisée en ce que cette cellule ne comporte qu'une région diffusée unique dans le substrat, cette région unique étant dopée avec des impuretés d'un type opposé aux impuretés qui dope le substrat alentour de cette région unique.

4. Cellule selon l'une quelconque des revendications 1 à 3, caractérisée en ce qu'on repousse la fenêtre tunnel vers le bord de la grille flottante.

5. Cellule mémoire selon l'une quelconque des revendications 1 à 4 caractérisé en ce que la région unique est dopée avec une implantation de type LDD.

6. Procédé de lecture d'une cellule mémoire selon l'une quelconque des revendications 1 à 5 dans une mémoire munie de cellules avec dispositif à grille flottante, ces dispositifs comportant une grille de commande reliée à une ligne de mot et une région source, ou une région drain, reliée à une ligne de bit, cette cellule étant dans un état programmée ou effacée, le seuil de conduction d'un canal de conduction du dispositif à grille flottante étant plus faible dans l'état programmé que dans l'état effacé, caractérisé en ce que

- on précharge les lignes de bit à une tension dont la valeur est au moins égale à la valeur absolue du seuil de conduction de la cellule pour un état programmé,
- on sélectionne la ligne de bit et la ligne de mot concernées par la cellule à lire, et
- on compare à une tension de référence la tension restant sur la ligne de bit sélectionnée et on en déduit l'état lu en fonction de la différence détectée entre ladite tension de référence et la tension restant sur la ligne, ladite différence étant représentative de l'état du bit.

7. Procédé selon la revendication 6 la cellule mémoire étant selon la revendication 2, caractérisé en ce qu'on relie la région drain du dispositif à grille flottante à une région source de ce dispositif.

8. Procédé selon l'une quelconque des revendications 6 ou 7, caractérisé en ce que

- on programme toutes les cellules d'une première ligne de bit de référence,
- on efface toutes les cellules d'une deuxième ligne de bit de référence,
- on relie entre elles ces deux lignes de bit de référence, et
- on se sert de leur tension commune résultant de la précharge comme tension de référence pour la comparer à la tension à lire.

**Patentansprüche**

1. Speicherzelle eines Speichers auf einer integrierten Schaltung, die in einem Halbleitersubstrat ist, Hergestellt, mit einem Steuergitter, das ein offenes Gitter steuert und von ihm isoliert ist, wobei dieses offene Gitter vom Halbleitersubstrat isoliert ist, wobei diese Isolierung mindestens ein Fenster aus einem Oxid mit Tunneleffekt aufweist, dadurch gekennzeichnet, daß diese Zelle nur eine einzige im Substrat verbreitete Region umfaßt, wobei dieses Gitter diese einzige Region dieses Substrats an der Stelle dieses Fensters aus Oxid mit Tunneleffet teilweise überragt, wobei diese einzige Region mit Fremdstoffen eines entgegengesetzten Typs dotiert ist im Vergleich zu den Fremdstoffen, die das Substrat um diese einzige Region herum dotieren.

2. Speicherzelle eines Speichers auf einer integrierten Schaltung, die in einem Halbleitersubstrat ist, hergestellt mit einem Steuergitter, das ein offenes Gitter steuert und von ihm isoliert ist, wobei dieses offene Gitter vom Halbleitersubstrat isoliert ist, wobei diese Isolierung ein Fenster aus einem Oxid mit Tunneleffekt aufweist, über einem Leitungskanal eines im Halbleitersubstrat angeordneten Transistors, dadurch gekennzeichnet, daß die Drain- und Source-Regionen dieses Transistors elektrisch miteinander verbunden sind.

3. Speicherzelle eines Speichers auf einer integrierten Schaltung, die in einem Halbleitersubstrat ist, hergestellt mit einem Steuergitter, das ein offenes Gitter steuert und von ihm isoliert ist, wobei dieses offene Gitter durch ein Oxid mit Tunneleffekt vom Halbleitersubstrat isoliert ist, dadurch gekennzeichnet, daß diese Zelle nur eine einzige im Substrat gestreute Region umfaßt, wobei diese einzige Region mit Fremdstoffen eines entgegengesetzten Typs dotiert ist im Vergleich zu den Fremdstoffen, die das Substrat um diese einzige Region herum dotieren.

4. Zelle nach einem der Ansprüche 1 bis 3, dadurch gekennzeichnet, daß man das Tunnelfenster zum Rand des offenen Gitters hin zurückstößt.

5. Speicherzelle nach einem der Ansprüche 1 bis 4, dadurch gekennzeichnet, daß die einzige Region mit einer Implantation des Typs LDD dotiert ist.

6. Leseverfahren einer Speicherzelle nach einem der Ansprüche 1 bis 5 in einem Speicher, der mit Zellen mit einer offenen Gittervorrichtung ausgerüstet ist, wobei diese Vorrichtungen ein Steuergitter umfassen, das mit einer Wortzeile verbunden ist, und eine Source-Region, bzw. eine Drain-Region, die mit einer Bitzeile verbunden ist, wobei sich diese Zelle in einem programmierten oder gelöschten Zustand befindet, wobei die Leitungsschwelle eines Leitungskanals der offenen Gittervorrichtung in programmiertem Zustand geringer ist als in gelöschtem Zustand, dadurch gekennzeichnet, daß

- diese Bitzeilen mit einer Spannung vorbeaufschlagt werden, deren Wert zumindest dem Absolutwert der Leitungsschwelle der Zelle für einen programmierten Zustand entspricht,
- die von der zu lesenden Zelle betroffenen Bit- und Wortzeilen ausgewählt werden, und
- die auf der ausgewählten Bitzeile verbleibende Spannung mit einer Referenzspannung vergleicht wird, wovon der abgelesene Zustand entsprechend der zwischen der besagten Referenzspannung und der auf der Zeile verbleibenden Spannung festgestellten Differenz abgleitet wird, wobei die besagte Differenz den Zustand des Bits darstellt.

7. Verfahren nach Anspruch 6, wobei die Speicherzelle nach Anspruch 2 ausgebildet ist, dadurch gekennzeichnet, daß man die Drainregion der offenen Gittervorrichtung mit einer Source-Region dieser Vorrichtung verbindet.

8. Verfahren nach einem der Ansprüche 6 oder 7, dadurch gekennzeichnet, daß

- alle Zellen einer ersten Referenzbitzeile programmiert werden,
- alle Zellen einer zweiten Referenzbitzeile gelöscht werden,
- diese beiden Referenzbitzeilen miteinander verbrenden werden, und
- ihre gemeinsame, sich aus der Vorbeaufschlagung ergebende Spannung als Referenzspannung benutzt wird, um mit der abzulesenden Spannung verglichen zu werden.

## Claims

1. A memory cell of an integrated circuit memory made in a semiconductor substrate, consisting of a control grid that controls and is insulated from a "floating grid", this floating grid being itself insulated from the semiconductor substrate, this insulation having at least one window made of a tunnel-effect oxide, characterized in that this cell has only one unique diffusion region in the substrate, this grid partly overlying this unique region of the substrate, at this tunnel-effect oxide window, this unique region being doped with impurities of a type opposite from the impurities doping the substrate around this unique region.

2. A memory cell of an integrated circuit memory made in a semiconductor substrate, including a control grid that controls and is insulated from a "floating grid", this floating grid being itself insulated from the semiconductor substrate, this insulation having at least one window made of a tunnel-effect oxide, above a conduction channel of a transistor made in the semiconductor substrate, characterized in that the drain and source regions of this transistor are electrically connected.

3. A memory cell of an integrated circuit memory made in a semiconductor substrate, consisting of a control grid that controls and is insulated from a "floating grid", this floating grid being itself insulated from the semiconductor substrate by a tunnel-effect oxide, characterized in that this cell has only one unique diffusion region in the substrate, this unique region being doped with impurities of a type opposite from the impurities doping the substrate around this unique region.

4. A cell in accordance with one of claims 1 to 3, characterized in that, the tunnel window is moved toward the edge of the floating grid.

5. A memory cell in accordance with one of claims 1 to 4, characterized in that the unique region is doped with an LDD type lay-out.

6. A method for reading a memory cell in accordance with one of claims 1 to 5 in a memory equipped with cells with floating grid device, these devices including a control grid connected to a word line and a source region, or a drain region, connected to a bit line, this cell being in a programmed or erased state, the floating grid device's conduction channel threshold being less in the programmed state than in the erased state, characterized in that :

- the bit lines are precharged to a voltage at least equal to the cell's absolute conduction threshold value for a programmed state,
- the bit line and the word line for the cell to be read are selected, and
- the voltage remaining on the selected bit line is compared to a reference voltage and the state read is determined on the basis of the difference detected between said reference voltage and the voltage remaining on the line, said difference representing the bit's state.

7. A method in accordance with claim 6, with the memory cell in accordance with claim 2, characterized in that the floating grid device's drain region is connected to a source region on this device.

8. A method in accordance with one of claims 6 or 7, characterized in that:

- all of the cells of an initial reference bit line are programmed,
- all of the cells of a second reference bit line are erased
- these two reference bit lines are connected together, and
- their common voltage resulting from the precharge is used as a reference voltage for comparison with the voltage to be read.

FIG_1a

FIG_1b

FIG_1c

FIG_2a

FIG_2b

EP 0 516 516 B1

FIG_4a — PRECH, 2,5V

FIG_4b — SELECTION BL

FIG_4c — SELECTION WL, 5V

FIG_4d — VBL SELECTION

FIG_4e — VBL NON SELECTION

FIG_4f — VWL SELECTION

FIG_4g — VWL NON SELECTION

LECTURE — ECRITURE EN PROGRAMMATION (un 0) — ECRITURE EN EFFACEMENT (un 1)

11

# FIG_5a

VPROG     |0     |0

0     Ecriture en
programmation
= écriture d'un 0

1/2 VPROG

1/2 VPROG

# FIG_5b

0     1/2VPROG  1/2VPROG

VPROG     Ecriture en
effacement
écriture d'un1

0

0

FIG_3

FIG_6

EP 0 516 516 B1